# FASCICULE DE BREVET EUROPEEN

(11) **EP 3 707 564 B1**
(45) Date de publication et mention de la délivrance du brevet: **31.08.2022**
(21) Numéro de dépôt: 18807436.3
(22) Date de dépôt: 12.11.2018
(51) Int. Cl.: G04B 15/06, G04B 15/14, G04B 31/02, G04B 9/00, G04B 5/18, G04B 3/04, B81B 3/00

(54) **ENSEMBLE HORLOGER COMPRENANT UN COMPOSANT HORLOGER ET UN DISPOSITIF POUR LE GUIDAGE EN TRANSLATION D'UN ELEMENT MOBILE**
ZUSAMMENSTELLUNG EINER UHRENKOMPONENTE UND EINER VORRICHTUNG ZUR STEUERUNG IN LÄNGSRICHTUNG EINER BEWEGLICHEN KOMPONENTE
HOROLOGICAL ASSEMBLY COMPRISING A HOROLOGICAL COMPONENT AND A DEVICE FOR GUIDING THE TRANSLATION OF A MOBILE COMPONENT

(30) Priorité: 10.11.2017 EP 17200973
(43) Date de publication de la demande: 16.09.2020
(73) Titulaire: Patek Philippe SA Genève, 1204 Genève (CH)
(72) Inventeur: LE BRIS, Jean-Baptiste, 74970 Marignier (FR)
(74) Mandataire: Micheli & Cie SA
(86) Numéro de dépôt international: PCT/IB2018/058866
(87) Numéro de publication internationale: WO 2019/092665

(56) Documents cités:
- EP-A1- 2 645 189
- WO-A1-2013/144236
- Pieter Pluimers: "Design for specified stiffness in precision engineering", , 2 octobre 2013 (2013-10-02), pages 1-92, XP055478292, Delft DOI: uuid:32441e78-8709-4620-a7ab-763ab53fb87e Extrait de l'Internet: URL:http://resolver.tudelft.nl/uuid:32441e 78-8709-4620-a7ab-763ab53fb87e [extrait le 2018-05-24]
- KYLER A. TOLMAN ET AL: "Compliant constant-force linear-motion mechanism", MECHANISM AND MACHINE THEORY, vol. 106, 1 décembre 2016 (2016-12-01), pages 68-79, XP055477345, AMSTERDAM, NL ISSN: 0094-114X, DOI: 10.1016/j.mechmachtheory.2016.08.009
- Juan Andrés Gallego: "Statically Balanced Compliant Mechanisms: Theory and Synthesis", Doctoral Thesis - TUDelft, 9 octobre 2013 (2013-10-09), pages 129-145, XP055478235, Delft ISBN: 978-94-618-6215-0 Extrait de l'Internet: URL:http://doi.org/10.4233/uuid:081e3d0e-1 73b-4a36-b8d6-c29c70eb7ae3 [extrait le 2018-05-24]

## Description

La présente invention concerne un ensemble horloger comprenant un composant horloger et un dispositif pour le guidage d'un élément mobile en translation.

Le brevet européen EP 2 607 968 B1 décrit un mécanisme d'échappement horloger comprenant une ancre d'échappement effectuant un mouvement alternatif en translation selon une direction de manière à se rapprocher et à s'éloigner de l'ancre de l'organe régulateur. Ce mécanisme d'échappement comprend des moyens de guidage en coulissement agencés pour coopérer avec des éléments d'appui solidaires d'un bâti d'une pièce d'horlogerie. De tels moyens de guidage présentent l'inconvénient d'engendrer des frottements et donc des pertes d'énergie.

La demande internationale WO2013/144236 décrit également un mécanisme d'échappement comprenant une ancre d'échappement effectuant un mouvement alternatif en translation. Le guidage en translation de l'ancre est réalisé au moyen de deux lames flexibles précontraintes en flambage, chacune de ces lames étant associée à un ressort de charge afin d'annuler sa rigidité. De tels moyens de guidage permettent d'éliminer les frottements mais présentent l'inconvénient d'engendrer une force de rappel élastique.

D'une manière générale, les guidages flexibles définissent un axe de déplacement uniquement virtuel pour le composant mobile et présentent l'avantage d'annuler les frottements. Cependant, ils présentent l'inconvénient d'engendrer une force de rappel qui, dans certaines utilisations, est indésirable ou trop importante, une telle force engendrant une surconsommation d'énergie.

Pour diminuer cette force de rappel une possibilité consistant à réaliser des guidages flexibles avec des lames présentant de très faibles raideurs n'est pas convenable car des lames de très faible raideur sont généralement fines et donc fragiles et difficiles à fabriquer. De plus, des lames de très faible raideur entraînent un guidage moins précis qu'un guidage avec des lames plus épaisses et autorisent notamment des déplacements parasites en dehors du plan défini par l'élément à guider lors de son déplacement en translation. En outre, une telle méthode ne peut permettre d'annuler complètement la force de rappel.

Un but de la présente invention est de proposer un ensemble horloger comprenant un composant horloger et un dispositif de guidage d'un élément mobile en translation, ledit dispositif de guidage étant précis et permettant d'annuler les frottements tout en atténuant voire en supprimant toute force de rappel.

L'invention propose à cette fin un ensemble horloger caractérisé selon la revendication 1 annexée.

Le composant horloger est typiquement solidaire en translation de l'élément mobile. En particulier, l'élément mobile peut comprendre ledit composant horloger.

Alternativement, le composant horloger peut être agencé pour coopérer avec l'élément mobile lorsque celui-ci est mobile en translation.

Dans le contexte de la présente invention, l'expression « composant horloger » peut désigner une partie seulement d'un composant horloger.

L'invention propose également un procédé selon la revendication 17 de réalisation d'un tel ensemble, ainsi qu'une pièce d'horlogerie selon la revendication 20 telle qu'une montre-bracelet, une montre de poche, une pendule ou une pendulette comprenant un tel ensemble. D'autres caractéristiques et avantages de la présente invention apparaîtront à la lecture de la description détaillée suivante faite en référence aux dessins annexés dans lesquels :
- la figure 1 est une vue en perspective d'un dispositif selon un premier mode de réalisation de l'invention ;
- les figures 2a et 2b sont des représentations schématiques en vue de dessus d'une unité isolée du dispositif représenté à la figure 1 respectivement au repos et pré-armée ;
- la figure 3 (courbe C₀) est une représentation graphique de la force de rappel élastique exercée dans l'unité isolée de la figure 2b ;
- la figure 4 représente graphiquement la force de rappel élastique exercée par une lame travaillant en flambage appartenant à l'unité isolée représentée à la figure 2b (courbe C₁) ainsi que la contrainte maximale de Von Mises exercée sur cette lame (courbe C₂) ;
- la figure 5 représente graphiquement la force de rappel élastique exercée par un ensemble de lames travaillant en flexion appartenant à l'unité isolée représentée à la figure 2 (courbe C₃) ainsi que la contrainte maximale de Von Mises exercée sur cet ensemble de lames (courbe C₄) ;
- la figure 6 est une représentation dans un même graphique des courbes Co, C₁ et C₃.
- les figures 7a et 7b sont des représentations schématiques en vue de dessus décrivant des étapes successives de la réalisation du dispositif représenté à la figure 1 ;
- les figures 7c et 7d sont des représentations schématiques en vue de dessus décrivant différentes configurations du dispositif représenté aux figures 1 et 7b;
- les figures 8a et 8b sont des schémas illustrant l'état d'armage de chacune des unités du dispositif représenté respectivement aux figures 7a et 7b ; la figure 8c est un schéma illustrant l'état d'armage de chacune des unités du dispositif représenté à la figure 10b ;
- la figure 9 est une représentation graphique de la force de rappel élastique exercée dans chacune des unités du dispositif de la figure 7b ainsi que de la force de rappel élastique exercée sur un élément à guider joint à des parties de liaison appartenant aux deux unités de ce dispositif lors de son déplacement en translation par rapport à un ensemble comprenant des supports faisant également partie desdites deux unités ;
- les figures 10a et 10b sont des représentations schématiques en vue de dessus décrivant des étapes successives de la réalisation d'un dispositif selon un second mode de réalisation de l'invention ;
- la figure 11 est une représentation graphique de la force de rappel élastique exercée dans chacune des unités du dispositif de la figure 10b ainsi que de la force de rappel élastique exercée sur un élément à guider joint à des parties de liaison appartenant aux deux unités de ce dispositif lors de son déplacement en translation par rapport à un ensemble comprenant des supports faisant également partie desdites deux unités ;
- la figure 12 est une vue de dessus d'un dispositif selon le premier mode de réalisation de l'invention intégré dans un mécanisme horloger.

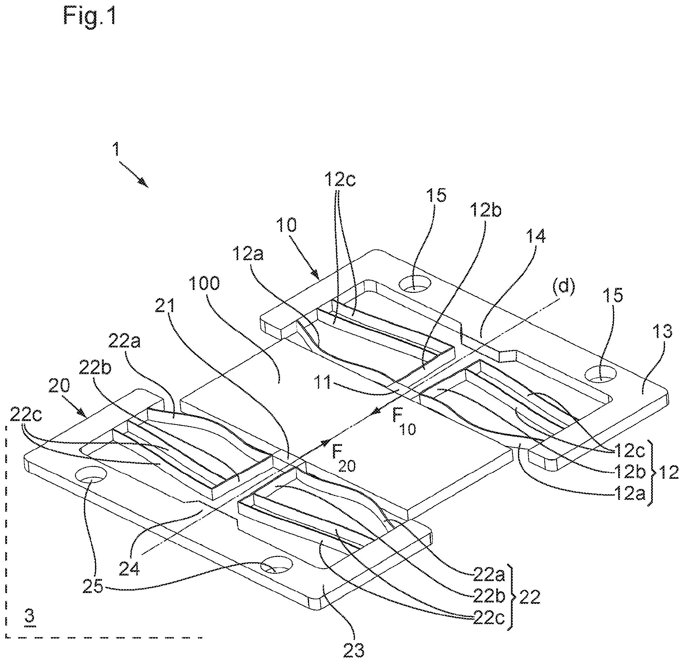

La figure 1 représente un dispositif 1 destiné à être utilisé dans un ensemble selon un premier mode de réalisation de l'invention, ledit dispositif 1 comprenant une première 10 et une deuxième 20 unité monolithique se faisant face et un élément rigide mobile à guider en translation 100. Chacune des unités 10, 20 comprend une partie de liaison 11, 21, rigide et mobile, jointe à l'élément à guider 100 et un organe élastique 12, 22 reliant cette dernière à un support 13, 23 rigide. Chacun des supports 13, 23 est en une seule partie dans le dispositif 1 représenté à la figure 1 mais pourrait comprendre plusieurs parties fixes les unes par rapport aux autres, par exemple plusieurs parties fixées sur un même bâti. L'ensemble des supports 13, 23 du dispositif 1 représenté à la figure 1 constitue un élément fixe en deux parties fixes l'une par rapport à l'autre mais pourrait également être en une seule partie.

Chaque organe élastique 12, 22 comprend typiquement :
- une lame élastique 12a, 22a travaillant en flambage, ladite lame 12a, 22a étant interrompue dans sa partie centrale par la partie de liaison 11, 21 et ayant ses deux extrémités jointes audit support 13, 23 ;
- une paire de lames élastiques de jonction 12b, 22b travaillant en flexion, une des extrémités de chaque lame de ladite paire étant reliée à la partie de liaison 11, 21 et s'étendant de cette partie de liaison 11, 21 vers le support 13, 23 ; et
- deux paires de lames élastiques 12c, 22c parallèles, travaillant en flexion et reliant la paire de lames élastiques de jonction 12b, 22b au support 13, 23.

Avantageusement, toutes les lames élastiques d'une unité donnée se situent dans un même plan. Cela présente l'avantage de limiter l'espace occupé par les unités et évite des frottements que l'on pourrait observer entre des lames superposées.

Le support 13, 23 de chacune des unités 10, 20 est fixé sur un bâti 3, la partie de liaison 11, 21 étant mobile par rapport au support 13, 23. Le bâti 3 peut être fixe ou mobile et comprend typiquement une platine, un pont ou une cage de tourbillon d'un mécanisme horloger.

La partie de liaison 11, 21 de chacune des unités 10, 20 est guidée en translation par l'organe élastique 12, 22 de ladite unité 10, 20 et se déplace le long d'une droite (d).

Chacune des parties de liaison 11, 21 est jointe à l'élément à guider 100 par tout moyen convenable, par exemple par la réalisation d'une structure monolithique ou bien par assemblage, par exemple par collage, vissage, soudure, brasage, chassage sur goupilles, clipsage ou autre.

Les parties de liaison 11, 21 et l'élément à guider 100 peuvent donc se déplacer en translation le long de la droite (d) définie précédemment.

Dans l'exemple représenté à la figure 1, pour chaque unité 10, 20, l'ensemble comprenant l'organe élastique 12, 22 et la partie de liaison 11, 21 est symétrique par rapport à cette droite (d).

Au sein du dispositif 1, chacun des organes élastiques 12, 22 est pré-armé et exerce une force respectivement F₁₀, F₂₀ tendant à éloigner l'élément à guider 100 du support 13, 23 auquel il est associé. Les unités 10, 20 étant placées face à face, en opposition, les forces F₁₀ et F₂₀ sont opposées, comme représenté par les flèches F₁₀ et F₂₀ à la figure 1.

Chaque lame élastique 12a et 22a est ici préformée droite et travaille en flambage sous l'effet de son pré-armage. Les lames élastiques 12a et 22a pourraient cependant être préformées flambées, c'est-à-dire usinées avec une forme flambée. Encore une autre possibilité consisterait en l'utilisation de lames élastiques 12a, 12b préformées droites puis comprimées lors de l'assemblage des unités 10, 20.

Le déplacement des parties de liaison 11, 21 dans le sens opposé aux flèches F₁₀, F₂₀ peut être limité par des butées 14, 24 faisant partie des supports 13, 23.

Les deux unités 10, 20 du dispositif 1 représenté à la figure 1 sont identiques (en particulier les organes élastiques 12, 22 ont la même forme).

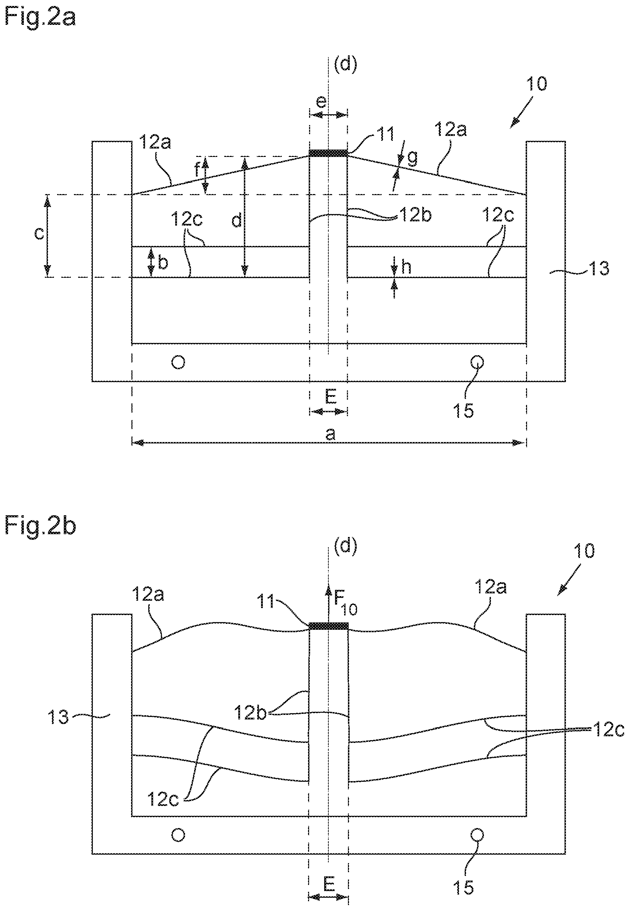

Pour la compréhension de l'invention, le comportement de chaque unité 10, 20 du dispositif 1, considérée isolément, c'est-à-dire libre de toute interaction avec l'élément à guider 100 ou avec l'autre unité, et sans butée 14, 24, est décrit ci-dessous. Les figures 2a et 2b représentent l'unité 10 isolée.

L'unité 10 isolée représentée à la figure 2a peut être armée par translation de sa partie de liaison 11 le long de la droite (d) dans la direction entraînant un effort de compression sur la lame élastique 12a et son flambage, c'est-à-dire dans la direction de son support 13 (sens d'armage) d'une distance Δ₁₀. La position dans laquelle Δ₁₀=0 correspond à la position de repos de l'unité 10 isolée, c'est-à-dire à la position dans laquelle toutes les lames élastiques de son organe élastique 12 sont au repos (n'exercent aucune force de rappel élastique) et la valeur de Δ₁₀ augmente lorsque sa partie de liaison 11 se rapproche de son support 13. La figure 2a représente l'unité 10 isolée dans ladite position de repos. Lorsque l'organe élastique 12 est au repos, la droite (d) est typiquement sensiblement parallèle aux lames de jonction 12b et sensiblement équidistante de chacune desdites lames 12b.

Lors de l'armage, l'organe élastique 12 de l'unité 10 se déforme pour exercer, dans l'unité 10 armée, une force de rappel F₁₀(Δ₁₀) dans le sens opposé au sens d'armage, cette force dépendant de la position Δ₁₀ de la partie de liaison 11 et tendant à faire revenir l'unité 10 dans sa position de repos, c'est-à-dire à éloigner la partie de liaison 11 du support 13.

La figure 2b représente l'unité 10 isolée après armage. La flèche F₁₀ représentée à la figure 2b illustre la force de rappel F₁₀(Δ₁₀).

L'unité 10 représentée aux figures 2a et 2b correspond à une unité particulière réalisée par la demanderesse dont les dimensions sont, lorsque elle est à l'état de repos, celles indiquées dans le tableau 1 ci-dessous.

**Tableau 1: Dimensions de l'unité particulière 10 réalisée par la demanderesse, isolée et à l'état de repos**

| Référence | Grandeur | Valeur | Unité |
|---|---|---|---|
| a | Longueur | 10 | mm |
| b | Espace entre lames en flexion 12c | 0.94 | mm |
| c | Espace entre lame 12 a et lame inférieure 12c | 2.5 | mm |
| d | Largeur | 3.7 | mm |
| E | Espace d'ouverture E de l'unité 10 (au repos) | e = 0.94 | mm |
| f | Flèche de la lame 12a | 1.2 | mm |
| g | Epaisseur lame 12a | 40 | µm |
| h | Epaisseur lames 12b et 12c | 47.46 | µm |
| - | Hauteur des lames | 0.3 | mm |

Les grandeurs **g** « épaisseur lame 12a » et **h** « épaisseur lames 12b et 12c » se mesurent dans le plan dans lequel est représenté l'organe moteur 1 tandis que la grandeur « hauteur » se mesure perpendiculairement à ce plan.

Comme cela est visible à la figure 2b, les lames élastiques de jonction 12b travaillant en flexion donnent un degré de liberté aux lames élastiques 12c qui peuvent s'écarter, augmentant ainsi la valeur de la distance E (cf. figure 2b). Ce degré de liberté est nécessaire pour le bon fonctionnement du mécanisme, cependant, il pourrait être obtenu par tout autre moyen convenable. La valeur de E dépend donc de l'état d'armage de l'unité 10.

Avant le pré-armage de l'unité 10, l'espace d'ouverture E a une valeur de 0,94mm égale à l'espace « e » séparant les lames 12b au niveau de la partie de liaison 11.

Lorsque l'unité 10 est pré-armée d'une valeur Δ₁₀ₐᵣₘ, l'espace d'ouverture E vaut « e' » et, lorsque, en fonctionnement, l'unité 10 est armée d'une valeur Δ₁₀ₘₐₓ, l'espace d'ouverture E vaut « e" ».

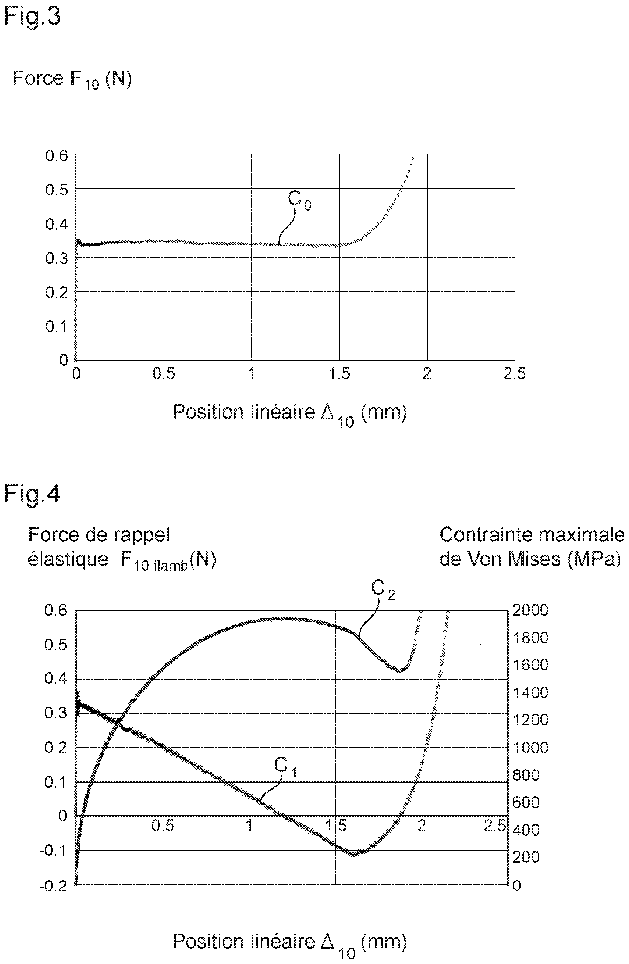

En référence à la figure 3, soit Δ₁₀ la position de la partie de liaison 11 de l'unité 10 isolée le long de la droite (d), tel que défini précédemment ; la figure 3 représente l'évolution F₁₀(Δ₁₀) de la force F₁₀ exercée par la partie de liaison 11 en direction de la flèche F₁₀, cette force étant la résultante des forces de rappel élastique exercées par les lames élastiques 12a, 12b et 12c de l'organe élastique 12. Les valeurs de la force F₁₀(Δ₁₀), pour chaque position Δ₁₀, correspondent à la force nécessaire pour maintenir la partie de liaison 11 dans la position Δ₁₀ correspondante. Ces valeurs sont issues d'une simulation de l'évolution de la force de rappel élastique de l'unité 10 particulière isolée réalisée par la demanderesse en fonction de la position Δ₁₀.

Comme cela est visible sur le graphique de la figure 3 (courbe Co), cette force suit une évolution en plusieurs phases :
- pour une position Δ₁₀ comprise entre 0 et une première valeur, la force de rappel élastique augmente rapidement avec la position Δ₁₀ ; cette phase correspond à la phase d'armage ;
- au-delà de cette première valeur, l'unité 10 est dans une phase stable. En effet, entre cette première valeur et une seconde valeur, la force de rappel élastique est sensiblement constante par rapport à la position Δ₁₀, c'est-à-dire qu'elle ne varie pas de plus de 10%, de préférence 5%, de préférence 4%, de préférence 3%, de préférence 2%, de préférence encore 1%, sur la plage de positions comprise entre lesdites première et deuxième valeurs.
- au-delà de cette deuxième valeur, la force de rappel élastique augmente à nouveau jusqu'à atteindre une valeur limite F₁₀ₗᵢₘᵢₜₑ, pour un déplacement Δ₁₀ = Δ₁₀ₗᵢₘᵢₜₑ. Cette valeur F₁₀ₗᵢₘᵢₜₑ dépend des propriétés du matériau dans lequel l'unité 10 est réalisée et est atteinte lorsque l'unité 10 subit la contrainte maximale qu'elle peut supporter.

L'unité particulière isolée 10 étudiée à la figure 3 est réalisée en acier sulem H1 CK101 (acier de construction non-allié) mais tout matériau approprié peut être utilisé. Par exemple des matériaux tels que le silicium typiquement revêtu d'oxyde de silicium, le Nivaflex^{®} 45/18 (alliage à base de cobalt, nickel et chrome), le plastique ou le verre métallique conviennent également et permettent l'obtention d'unités dont la force de rappel élastique est sensiblement constante sur les mêmes plages de positions mais avec des intensités différentes.

La plage de positions permettant la délivrance d'une force de rappel sensiblement constante étant une constante liée à la forme des lames élastiques, la contrainte maximale subie par les lames élastiques doit être inférieure ou égale à la limite élastique (Fₗᵢₘᵢₜₑ) du matériau dans lequel elles sont fabriquées. Lors de l'utilisation du dispositif selon l'invention, il sera donc important de ne pas dépasser Δ₁₀ₗᵢₘᵢₜₑ pour ne pas plastifier ou casser les lames.

Le choix du matériau dépend de l'application. Les différents matériaux utilisables cités ci-dessus, aux dimensions considérées, peuvent subir, sans risque de déformation plastique ou de rupture, des contraintes (de Von Mises) allant jusqu'à 2100 MPa.

L'unité 10 isolée présentant une évolution de la force F₁₀(Δ₁₀) telle que représentée à la figure 3 diffère des structures élastiques classiques. Ses propriétés reposent sur l'association de différents types de lames élastiques dont les propriétés sont spécifiquement choisies ainsi que sur leur agencement permettant l'addition de leurs forces de rappel élastique.

La courbe C₁ de la figure 4 illustre (en N) la force de rappel élastique F_{10flamb} associée à la lame élastique 12a travaillant en flambage en fonction de la position Δ₁₀ de la partie de liaison 11 de l'unité 10 isolée par rapport à son support 13, le long de la droite (d). On remarque que pour une certaine plage de valeurs de Δ₁₀ s'étendant, dans cette unité 10 particulière, d'environ 0,01 mm à environ 1,6 mm, la courbe C₁ associée à la lame 12a est sensiblement droite, de coefficient directeur environ égal à -0,28. Une régression linéaire a été effectuée et donne une équation de droite y=-0,2777x + 0,3367 avec R² = 0,999. La lame élastique 12a du dispositif 1 présente donc, sur cette plage de valeurs au moins, une raideur négative.

La capacité de la lame élastique 12a à travailler en flambage lui permet, lorsqu'elle est considérée isolément, de se comporter comme un bistable ou du moins de posséder une raideur linéaire négative sur une plage de positions données. L'ajustement du rapport entre la flèche f de la lame 12a au repos et son épaisseur ainsi que l'ajustement de sa longueur, de sa hauteur et de son matériau permettent de moduler la linéarité de la portion de droite sur laquelle la lame 12a possède une raideur négative.

La courbe C₂ de cette même figure 4 illustre, quant à elle, la contrainte maximale de Von Mises (en MPa) exercée sur la lame 12a en fonction de la position Δ₁₀. Il est à noter que la contrainte de Von Mises exercée sur la lame 12a est inférieure à 2100 MPa sur toute la plage de positions Δ₁₀ allant de 0,01mm à 1,6mm. En effet, elle n'atteint 2000MPa qu'à partir d'une position Δ₁₀ supérieure à 2mm environ.

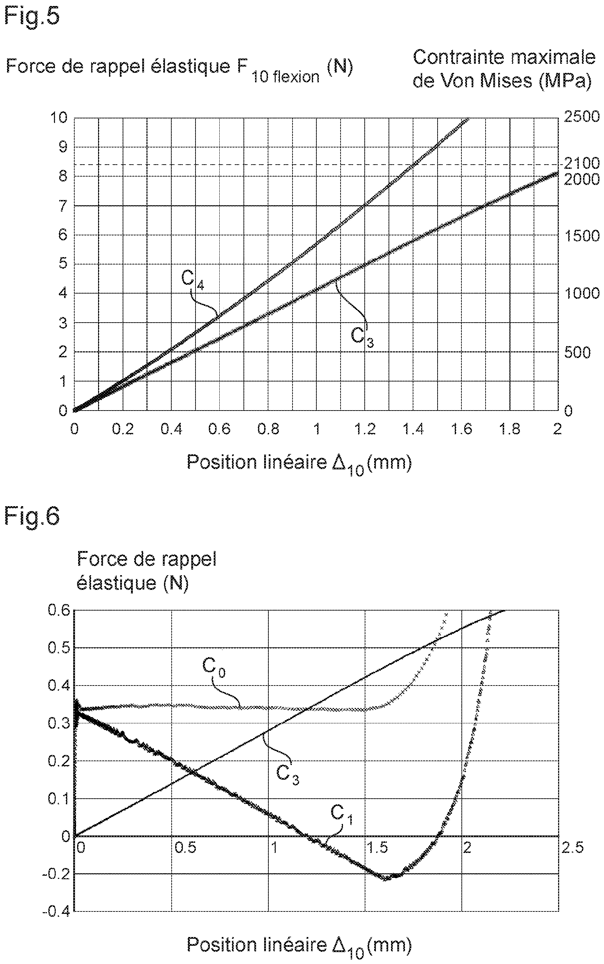

La courbe C₃ de la figure 5 illustre, la force de rappel élastique F_{10flexion} associée à l'ensemble des lames 12b, 12c travaillant en flexion en fonction de la position Δ₁₀ de la partie de liaison 11 de l'unité 10 isolée par rapport à son support 13, le long de la droite (d). Comme c'est le cas pour tout type de ressort travaillant en flexion, la courbe C₃ illustrant la force de rappel élastique en fonction du déplacement est une droite sur une plage de valeurs donnée. Les lames 12b, 12c ont une raideur positive et sont choisies pour que la raideur de l'association des lames 12b, 12c en flexion soit environ égale à 0,28 c'est-à-dire pour que le coefficient directeur de la droite F_{10flexion}(Δ₁₀) soit environ égal à 0,28.

Ainsi les coefficients directeurs des portions de droites associées aux courbes C₁ (F_{10flamb}(Δ₁₀)) et C₃ (F_{10flexion}(Δ₁₀)) sont opposés. La courbe C₃ fléchit légèrement pour des valeurs de Δ₁₀ dépassant 1,6mm, et peut donc être considérée comme une droite de coefficient directeur environ égal à 0,28 pour des valeurs de Δ₁₀ comprises entre 0 et 1,6mm. Une régression linéaire a été effectuée et donne une équation de droite y=0,2814x + 0,0002 avec R² = 1.

La courbe C₄ de cette même figure 5 illustre, quant à elle, la contrainte maximale de Von Mises (en MPa) exercée sur l'ensemble des lames 12b et 12c travaillant en flexion en fonction de la position Δ₁₀. Il est à noter que la contrainte de Von Mises exercée sur cet ensemble de lames 12b, 12c est inférieure à 2100 MPa sur une plage de positions allant de 0 mm à 1,4 mm. Elle n'atteint 2100MPa qu'à partir d'une position Δ₁₀ d'environ 1,42 mm.

L'agencement des lames 12a, 12b et 12c de l'unité 10 est tel que la courbe C₀ de la figure 3 correspond à la somme des courbes C₁ et C₃ des figures 4 et 5, comme illustré à la figure 6. Ainsi, dans la mesure où les coefficients directeurs des portions de droites associées aux courbes C₁ et C₃ sont opposés, l'association de la raideur négative obtenue par le biais de la lame 12a travaillant en flambage avec la raideur positive obtenue par le biais des lames 12b, 12c travaillant en flexion, permet l'obtention d'une raideur sensiblement nulle, c'est-à-dire d'une force de rappel sensiblement constante, comme illustré aux figures 3 et 6.

L'ensemble des lames de l'organe élastique 12 de l'unité 10 du dispositif 1 est donc agencé pour exercer, dans cette unité 10, une force de rappel élastique F₁₀(Δ₁₀) sensiblement constante sur une plage de positions [Δ₁₀ₘᵢₙ, Δ₁₀ₘₐₓ] de la partie de liaison 11 de ladite unité 10 par rapport à son support 13.

On distinguera la plage [Δₘᵢₙ, Δₘₐₓ] théorique ([Δ_{min_théo}, Δ_{max_théo}]), correspondant à la plage de positions de la partie de liaison 11 de l'unité 10 par rapport à son support 13 dans laquelle l'unité 10 est potentiellement apte à exercer une force sensiblement constante de valeur F_{constante}, indépendamment de tout risque de rupture et/ou de déformation élastique, et la plage [Δₘᵢₙ, Δₘₐₓ] d'utilisation ([Δ_{min_utilisation}, Δ_{max_utilisation}]) correspondant à la plage de positions de la partie de liaison 11 de l'unité 10 par rapport à son support 13 dans laquelle l'unité 10 est apte à exercer une force sensiblement constante de valeur F_{constante}, sans risque de déformation plastique ou de rupture de l'une des lames élastiques de son organe élastique 12.

La plage de positions ([Δ_{min_théo}, Δ_{max_théo}]) correspond à la plage de recoupement des plages de positions dans lesquelles les courbes C₁ et C₃ sont droites. Cette plage de positions s'étend de Δ=0,01mm à Δ=1,6mm dans l'exemple illustré.

La plage ([Δ_{min_utilisation}, Δ_{max_utilisation}]), incluse dans la plage ([Δ_{min_théo}, Δ_{max_théo}]), prend en compte les données des courbes C₂ et C₄. Elle est restreinte à une plage de positions allant de Δ=0,01mm à Δ=1,4mm. En effet, les courbes C₂ et C₄ indiquent que pour des valeurs de Δ supérieures à 1,4mm (à partir de 1,42mm environ), la contrainte de Von Mises excède 2100MPa, c'est-à-dire que pour des valeurs de Δ supérieures à Δ_{max_utilisation}=1,4mm, l'organe élastique 12 de l'unité 10 risquerait une déformation plastique ou une rupture. Il est à noter toutefois que, en changeant le matériau utilisé pour la réalisation de cette unité 10, la limite au-delà de laquelle les lames présentent un risque de déformation plastique ou de rupture pourrait être supérieure à 2100MPa.

La force F_{constante} correspond à la valeur de la force F exercée entre les positions Δₘᵢₙ et Δₘₐₓ considérées (valeur du plateau). Cette force vaut 0,343N environ dans l'exemple illustré.

Dans la suite de la description, quelle que soit l'unité considérée, nous entendrons par plage de positions [Δₘᵢₙ, Δₘₐₓ], la plage [Δ_{min_utilisation}, Δ_{max_utilisation}]. Cette plage s'étend de Δ=0,01mm à Δ=1,4mm pour l'unité 10.

De manière analogue, l'unité 20 du dispositif 1 considérée isolée peut également, à partir de sa position de repos, être armée d'une distance Δ₂₀ par translation de sa partie de liaison 21 le long de la droite (d) dans son sens d'armage, c'est-à-dire dans le sens allant de sa partie de liaison 21 vers son support 23. La position dans laquelle Δ₂₀=0 correspond à la position de repos de l'unité 20 isolée, c'est-à-dire à la position dans laquelle toutes les lames de son organe élastique 22 sont au repos (n'exercent aucune force de rappel élastique) et la valeur de Δ₂₀ augmente lorsque sa partie de liaison 21 se rapproche de son support 23. La force de rappel élastique exercée par l'unité 20 et opposée à son sens d'armage est désignée par F₂₀.

De manière générale, lorsque la partie de liaison 11, 21 d'une unité 10, 20 est dans la position dans laquelle la valeur de Δ associée, respectivement Δ₁₀ ou Δ₂₀, est égale à x mm, on dit que l'unité 10, 20 est armée x mm.

Chaque unité 10, 20 du dispositif 1 possède une plage de positions, respectivement [Δ₁₀ₘᵢₙ, Δ₁₀max], [Δ₂₀min, Δ₂₀max] qui lui est propre, dans laquelle elle exerce une force de rappel élastique, respectivement F₁₀(Δ₁₀) et F₂₀(Δ₂₀), sensiblement constante. Dans le premier mode de réalisation de l'invention, les deux unités 10, 20 étant identiques, on a [Δ₁₀ₘᵢₙ, Δ₁₀ₘₐₓ] = [Δ₂₀min, Δ₂₀ₘₐₓ].

Le dispositif 1 est conçu de sorte que, lorsqu'il est au repos, c'est-à-dire lorsqu'aucune force extérieure ne s'exerce sur lui, et notamment lorsqu'aucune force extérieure ne tend à engendrer un déplacement de ses parties de liaison 11, 21 par rapport à ses supports 13, 23, chacune de ses deux unités 10, 20 est armée d'une valeur respectivement Δ₁₀ₐᵣₘ et Δ₂₀arm. On dit alors que les unités 10, 20 sont pré-armées respectivement de Δ₁₀ₐᵣₘ et de Δ₂₀ₐᵣₘ.

Comme déjà indiqué, les deux unités 10, 20 se font face de sorte que les forces F₁₀ et F₂₀ qu'elles exercent sont dans des sens opposés.

Au repos, les unités 10, 20 sont typiquement armées de la même valeur de sorte que Δ₁₀ₐᵣₘ = Δ₂₀ₐᵣₘ = Δₐᵣₘ. Δₐᵣₘ est, pour chaque unité 10, 20, inclus dans la plage [Δ₁₀ₘᵢₙ, Δ₁₀max], [Δ₂₀min, Δ₂₀max] qui lui est associée. Le dispositif 1 est alors dans une position dite « d'équilibre d'armage » dans laquelle les forces de rappel F₁₀(Δₐᵣₘ) et F₂₀(Δₐᵣₘ) respectivement exercées par les organes élastiques 12, 22 des unités 10, 20 se compensent théoriquement parfaitement F₁₀(Δₐᵣₘ) = - F₂₀(Δₐᵣₘ).

Des valeurs d'armage Δ₁₀ₐᵣₘ et Δ₂₀ₐᵣₘ différentes sont également possibles. En effet, quelle que soit la valeur d'armage de chacune des unités 10, 20, tant que, pour chacune des unités 10, 20, elle est comprise dans la plage de valeurs respectivement [Δ₁₀ₘᵢₙ, Δ₁₀ₘₐₓ], [Δ₂₀ₘᵢₙ, Δ₂₀ₘₐₓ] qui lui est associée, l'équation F₁₀(Δ₁₀ₐᵣₘ) ~ - F₂₀(Δ₂₀ₐᵣₘ) est vérifiée et le système est en position dite « d'équilibre d'armage ».

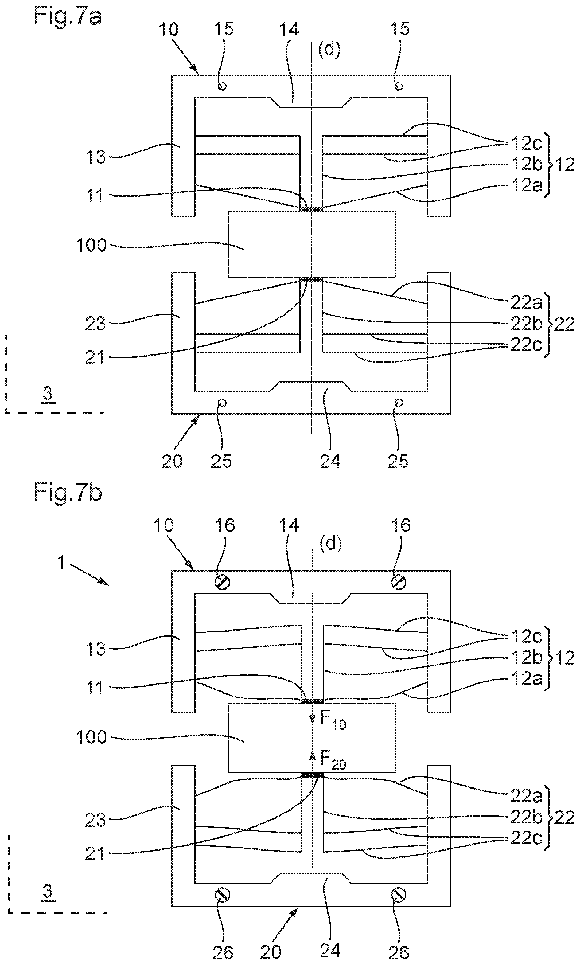

Les figures 7a et 7b sont des représentations schématiques décrivant des étapes successives de la réalisation du dispositif 1.

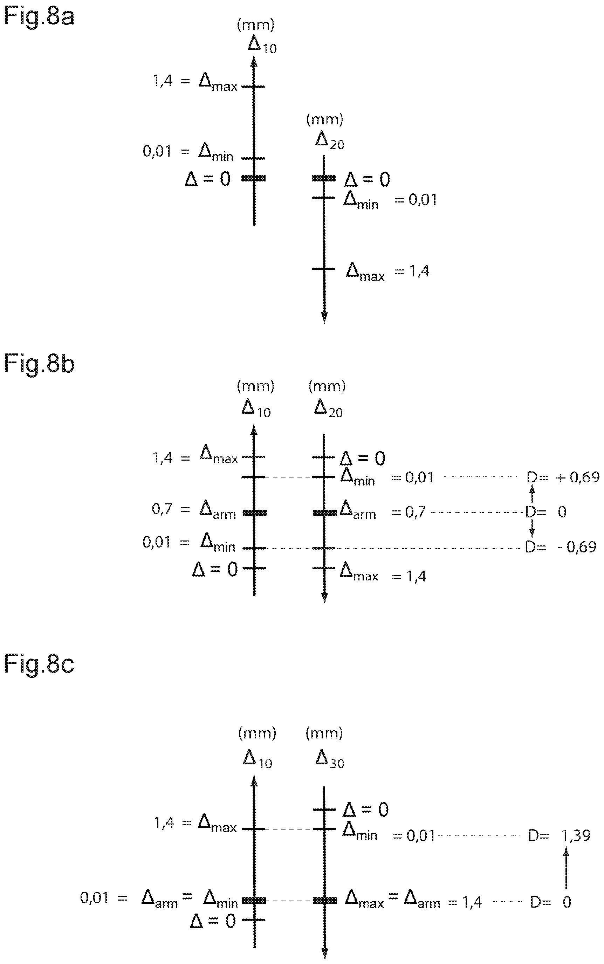

Afin d'obtenir un dispositif 1 tel que représenté à la figure 1 :
a) deux unités monolithiques 10, 20 identiques à l'unité particulière 10 développée par la demanderesse ont été réalisées, les parties de liaison 11, 21 de chacune de ces unités 10, 20 étant positionnées face à face et jointes à l'élément à guider 100. Le dispositif intermédiaire ainsi obtenu correspond au dispositif 1 avant armage, dans une position dans laquelle l'armage est nul pour chacune des unités (Δ₁₀ₐᵣₘ = Δ₂₀ₐᵣₘ = 0), c'est-à-dire dans une position dans laquelle les organes élastiques 12 et 22 sont au repos. La figure 7a illustre ce dispositif intermédiaire. La figure 8a illustre quant à elle schématiquement l'état d'armage des unités 10 et 20 de ce dispositif intermédiaire. Dans cette figure 8a, les repères « 0 » alignés respectivement sur les traits verticaux représentant les positions Δ₁₀ et Δ₂₀ de chacune des unités 10 et 20 servent d'index pour repérer l'état d'armage de ces unités 10, 20.
b) chacune des deux unités 10, 20 a ensuite été armée d'une même valeur Δₐᵣₘ par rapprochement des supports 13, 23 l'un de l'autre, le long de la droite (d), de sorte que sa partie de liaison 11, 21 exerce une force de rappel élastique sur l'élément à guider 100, repoussant cet élément à guider 100 vers l'autre unité 10, 20. Dans l'exemple illustré, Δ₁₀ₘᵢₙ = Δ₂₀ₘᵢₙ = 0,01mm, Δ₁₀ₘₐₓ = Δ₂₀ₘₐₓ = 1,4mm et Δ₁₀ₐᵣₘ = Δ₂₀ₐᵣₘ = Δₐᵣₘ = 0,7mm. Cet armage engendre une déformation des lames élastiques que comprennent les organes élastiques 12 et 22, ce qui est visible à la figure 7b.
c) les supports 13, 23 ont ensuite été fixés sur le bâti 3 dans cette position par insertion de vis 16, 26 dans les trous 15, 25 des supports 13, 23. Tout autre moyen de fixation approprié est envisageable. La figure 7b illustre le dispositif 1 obtenu à l'issue de cette étape c. La figure 8b illustre schématiquement l'état d'armage des unités 10 et 20 du dispositif 1 représenté à la figure 7b. Dans cette position, chacune des unités 10, 20 exerce une force de rappel élastique tendant à éloigner l'élément à guider 100 de son support 13, 23 de même valeur F₂₀(0,7)=F₁₀(0,7)=0,343 N mais dans des sens opposés.

Lorsque l'unité 10 est pré-armée d'une valeur Δ₁₀ₐᵣₘ = 0,7mm, l'espace d'ouverture E vaut « e' » et est égal à 1,074mm. Lorsque, en fonctionnement, l'unité 10 est armée d'une valeur Δ₁₀ₘₐₓ = 1,4mm, l'espace d'ouverture E vaut « e" » et est égal à 1,475mm.

Il apparaît clairement à l'homme du métier qu'un tel dispositif 1 peut être obtenu par une succession d'étapes différente.

Considérons le dispositif 1 obtenu à l'issue de l'étape c) ci-dessus. Soit D la position de l'élément à guider 100 par rapport au bâti 3, D étant égal à zéro dans la position d'équilibre d'armage et augmentant lors de la translation de l'élément à guider 100 le long de la droite (d) en direction de l'unité 10.

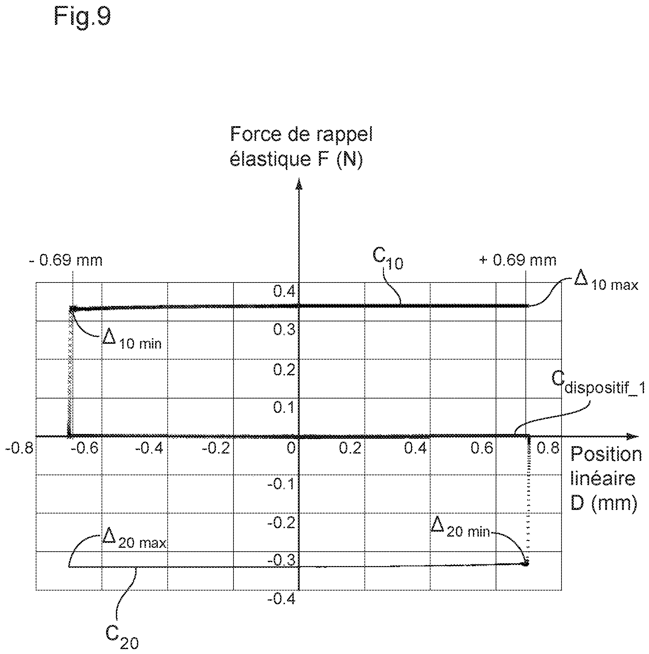

La courbe C₁₀ de la figure 9 correspond à la courbe F₁₀(**D**) de l'unité 10 et la courbe C₂₀ de la figure 9 correspond à la courbe F₂₀(**D**) de l'unité 20. Une force de rappel positive correspond à une force tendant à faire avancer l'élément à guider 100 le long de la droite (d), dans la direction de l'unité 20, c'est-à-dire vers le bas sur les figures 7a à 7d.

La courbe C₁₀ correspond à la courbe F₁₀(Δ₁₀) que l'on aurait pour l'unité 10 isolée et qui aurait subi, du fait de la phase d'armage, une translation de Δ₁₀ₐᵣₘ = 0,7mm vers la gauche. La force F₁₀ exercée par l'unité 10 tend à pousser l'élément à guider 100 vers l'unité 20 et est donc positive.

La courbe C₂₀ correspond à la symétrique de la courbe F₂₀(Δ₂₀) que l'on aurait pour l'unité 20 isolée par rapport au centre du repère et qui aurait subi une translation de Δ₂₀ₐᵣₘ = 0,7mm vers la droite. La force F₂₀ exercée par l'unité 20 tend à pousser l'élément à guider 100 vers l'unité 10 et est donc comptée négativement.

La courbe C_{dispositif_1} de la figure 9 illustre la force de rappel globale F(D) s'exerçant sur l'élément à guider 100 en fonction de sa position D, le long de la droite (d). Cette courbe correspond à la somme des courbes C₁₀ et C₂₀.

Comme cela est visible sur la figure 9, tant que la position D est telle que l'armage de chacune des deux unités 10, 20 reste dans la plage de valeurs [Δₘᵢₙ, Δₘₐₓ] = [0,01mm ; 1,4mm] qui lui est associée (c'est-à-dire dans la plage de valeurs [Δ₁₀ₘᵢₙ, Δ₁₀ₘₐₓ] pour l'unité 10 et dans la plage de valeurs [Δ₂₀min, Δ₂₀max] pour l'unité 20), les forces de rappel élastique exercées par les deux unités 10, 20 sur l'élément à guider 100 se compensent théoriquement complètement. Ainsi, la force de rappel résultante sur l'élément à guider 100 est sensiblement nulle. Cela correspond à une plage de positions prédéterminées D de l'élément à guider 100 allant de -0,69mm à +0,69mm, soit une plage prédéterminée de 1,38mm (cf. figures 8b et 9). Ainsi, la plage de positions prédéterminée du dispositif 1 selon le premier mode de réalisation de l'invention correspond à la plage de chevauchement des plages [Δ₁₀ₘᵢₙ, Δ₁₀ₘₐₓ] et [Δ₂₀min, Δ₂₀max] au sein du dispositif 1. Ladite plage de positions prédéterminée est typiquement d'au moins 1mm. Un déplacement de l'élément mobile à guider 100 en dehors de la plage [-0,69mm, +0,69mm] engendre un risque de déformation plastique ou de rupture des organes élastiques 12, 22 que comprend le dispositif 1. Les butées 14, 24 sont avantageusement aménagées pour limiter les déplacements de l'élément à guider 100 à la plage prédéterminée de positions permettant un guidage en translation sans force de rappel et sans risque d'endommager le dispositif 1.

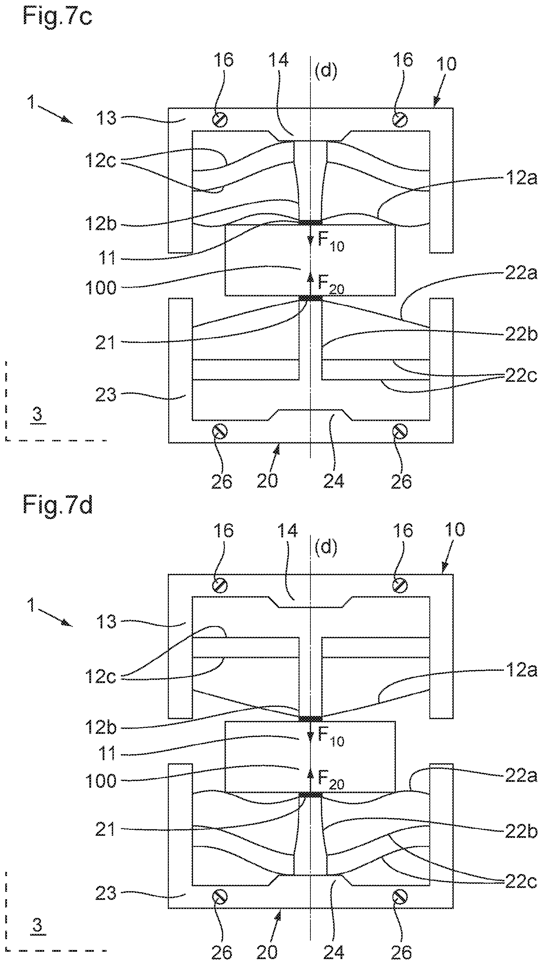

Les figures 7c et 7d représentent schématiquement le dispositif 1 dans les positions respectivement dans lesquelles D=+0,69mm et -0,69mm.

Dans le cas étudié, Δ₁₀ₐᵣₘ et Δ₂₀ₐᵣₘ sont centrés sur les plages [Δ₁₀ₘᵢₙ, Δ₁₀ₘₐₓ] et [Δ₂₀min, Δ₂₀ₘₐₓ].Ainsi, on obtient la plage de positions prédéterminée la plus étendue possible et un dispositif 1 de guidage « bidirectionnel à partir de sa position de repos », l'élément à guider 100 pouvant, à partir de sa position de repos, être entraîné en translation vers le haut de 0,69mm (jusqu'à D = 0,69mm) et vers le bas de 0,69mm (jusqu'à D = -0,69mm) en subissant une force de rappel élastique sensiblement nulle, comme illustré aux figures 8b et 9.

Δ₁₀ₐᵣₘ est donc de préférence égal à (Δ₁₀ₘᵢₙ + ((Δ₁₀ₘₐₓ-Δ₁₀ₘᵢₙ)/2)), de sorte que [Δ₁₀ₘᵢₙ, Δ₁₀ₐᵣₘ] = [Δ₁₀ₐᵣₘ, Δ₁₀ₘₐₓ] et Δ₂₀ₐᵣₘ est de préférence égal à (Δ₂₀ₘᵢₙ + ((Δ_{20max -} Δ₂₀ₘᵢₙ)/2)), de sorte que [Δ₂₀ₘᵢₙ, Δ₂₀ₐᵣₘ] = [Δ₂₀ₐᵣₘ, Δ₂₀ₘₐₓ].De cette façon, les unités 10, 20 exercent des forces de rappel F₁₀(Δ₁₁₀), F₂₀(Δ₂₀) se compensant presque totalement sur une plage de positions prédéterminée des parties de liaisons 11, 21 par rapport aux supports 13, 23 s'étendant de Δ₁₀ₘᵢₙ à Δ₁₀ₘₐₓ et de Δ₂₀ₘᵢₙ à Δ₂₀ₘₐₓ et pour une translation D de l'élément à guider 100 aussi bien vers l'unité 10 que vers l'unité 20.

Pour comparaison, si l'on avait armé chacune des unités 10, 20 du dispositif précédemment décrit d'une valeur Δ₁₀ₐᵣₘ = Δ₂₀ₐᵣₘ = Δₐᵣₘ = 0,5 mm, la plage prédéterminée de positions aurait été de 0,98mm, et si l'on avait armé l'unité 10 du dispositif précédemment décrit d'une valeur Δ₁₀ₐᵣₘ = 0,01mm et l'unité 20 du dispositif précédemment décrit d'une valeur Δ₂₀ₐᵣₘ = 1,4mm, la plage prédéterminée de positions aurait été de 1,39mm mais le dispositif de guidage aurait été « unidirectionnel à partir de sa position de repos », l'élément à guider 100 pouvant, à partir de sa position de repos, être entraîné en translation vers le haut de 1,39mm (jusqu'à D = 1,39mm) en subissant une force de rappel élastique sensiblement nulle.

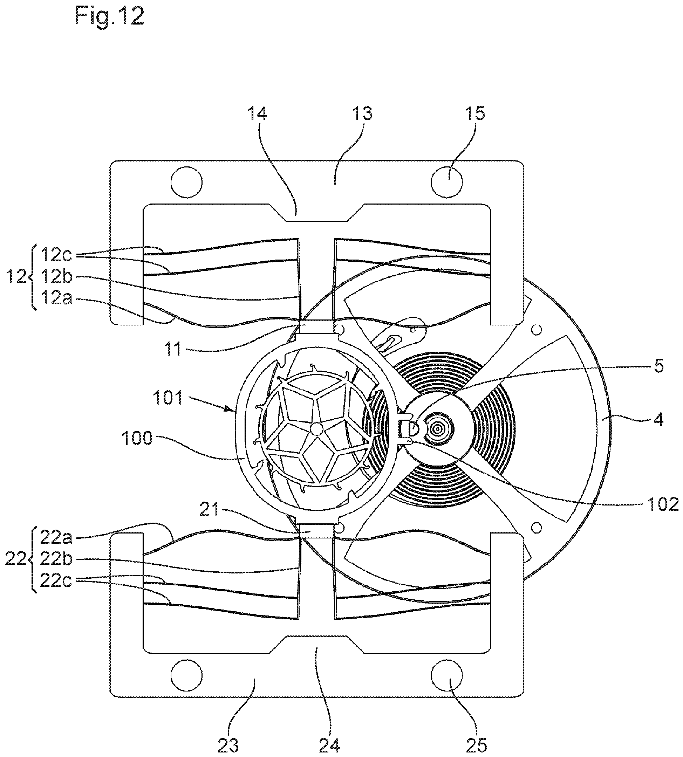

Un dispositif 1 selon le premier mode de réalisation de l'invention peut par exemple être utilisé pour guider en translation un composant horloger tel qu'une ancre d'échappement comme celle décrite dans le brevet EP 2 607 968 B1 ou dans la demande internationale WO2013/144236, effectuant un mouvement alternatif en translation. La figure 12 illustre une telle utilisation dans laquelle le cadre mobile de l'ancre d'échappement 101 est l'élément mobile 100 et est donc solidaire en translation des parties de liaison 11, 21, cette figure illustre un ensemble horloger selon le premier mode de réalisation de l'invention dans lequel l'élément mobile comprend le composant horloger. Le mécanisme horloger représenté à la figure 12 comprend un balancier spiral 4 dont la cheville de plateau 5 coopère avec les cornes 102 de l'ancre d'échappement 101.

Une ancre d'échappement guidée en translation par un dispositif 1 utilisant deux unités 10, 20 identiques à l'unité particulière réalisée par la demanderesse avec une valeur d'armage initiale de chaque unité de 0,7mm peut théoriquement se déplacer sur une plage de 1,38mm sans frottement et avec une force de rappel négligeable.

Un tel dispositif 1 peut également être utilisé dans un ensemble horloger pour guider en translation sans frottements ni force de rappel un mécanisme tel que décrit dans l'une des demandes internationales WO2018/193365 ou WO2018/193366 ainsi que pour le guidage de tout composant que l'on cherche à guider en translation sans frottement et avec une force de rappel la plus faible possible, typiquement pour le guidage d'une crémaillère, par exemple pour un affichage jour/nuit ou de réserve de marche en translation, d'une masse de remontage à mouvement linéaire, ou d'un système conjuguant came et bielle.

Le dispositif 1 peut également être utilisé dans un ensemble horloger pour guider en translation sans frottements ni force de rappel un élément mobile qui, lorsqu'il est mobile en translation, est destiné à coopérer avec un composant horloger tel qu'une roue dentée.

En variante, le dispositif de guidage de l'ensemble horloger selon le premier mode de réalisation de l'invention peut comprendre des unités différentes l'une de l'autre (dont la taille, le nombre, la forme et/ou le matériau des lames élastiques est différent entre l'une et l'autre), chacune desdites unités étant agencée au sein du dispositif pour exercer une force de rappel élastique sensiblement constante sur une plage prédéterminée de positions de sa partie de liaison par rapport à son support, la valeur de cette force sensiblement constante étant sensiblement la même pour les deux unités. En d'autres termes, les « plateaux » des courbes F(Δ) associées à chacune des deux unités correspondraient à des valeurs de force de rappel élastique sensiblement identiques. Dans cette variante, il est possible d'avoir des plages [Δₘᵢₙ, Δₘₐₓ] différentes d'une unité à l'autre.

Un dispositif 2 destiné à être utilisé dans un ensemble selon un second mode de réalisation de l'invention diffère du dispositif 1 en ce que ses deux unités ne sont pas identiques et présentent des courbes F(Δ) dont les « plateaux » correspondent à des valeurs de force de rappel élastique sensiblement différentes. Chacune des unités du dispositif 2 selon le second mode de réalisation de l'invention est apte à engendrer une force de rappel sensiblement constante sur une plage de positions de sa partie de liaison par rapport à son support, cette force de rappel s'exerçant dans un premier sens le long de la droite (d) et étant sensiblement égale à une première valeur X pour une première des deux unités et s'exerçant dans un second sens opposé au premier et sensiblement égale à une seconde valeur Y, différente de X pour une seconde desdites unités.

Un tel dispositif 2 permet un guidage en translation sans frottement, engendrant une force de rappel élastique sensiblement constante environ égale à |X-Y|. Un tel dispositif 2 peut être préféré au dispositif 1, par exemple lorsque l'on cherche à obtenir un guidage sans frottement et avec une force de rappel faible mais non sensiblement nulle, par exemple pour guider d'un poussoir, d'une tige de remontoir ou d'un doigt de lecture de came.

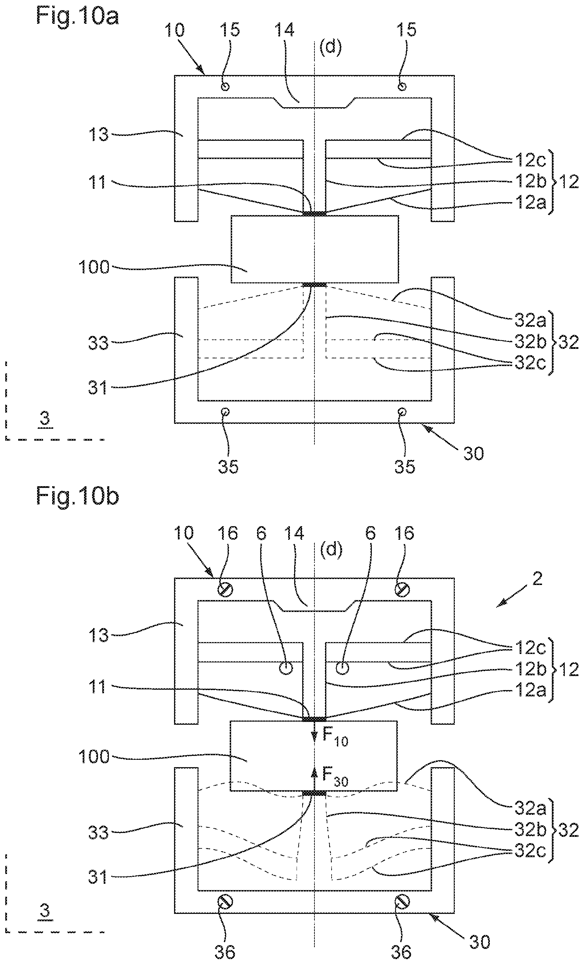

La figure 10b illustre un tel dispositif 2. La figure 10a illustre une étape de réalisation de ce dispositif, avant la phase d'armage.

Le dispositif 2 représenté à la figure 10b diffère du dispositif 1 représenté à la figure 7b en ce que ses deux unités 10, 30 ne sont pas identiques. Une première 10 de ses unités 10, 30 monolithiques est identique à l'unité particulière 10 utilisée dans le dispositif 1 et l'autre unité 30 diffère de la première unité 10 en ce que ses lames élastiques 32a, 32b et 32c, similaires aux lames 12a, 12b et 12c de l'unité 10, sont moins épaisses (représentation en pointillés) que les lames 12a, 12b et 12c (35µm d'épaisseur pour la lame 32a contre 40µm pour la lame 12a et 41,52µm d'épaisseur pour les lames 32b et 32c contre 47,46µm pour les lames 12b et 12c). L'unité 30 possède des propriétés similaires à celle de l'unité 10. Dans le dispositif 2 illustré à la figure 10b, les valeurs Δ₃₀ₘᵢₙ et Δ₃₀ₘₐₓ associées à l'unité 30 sont les mêmes que pour l'unité 10. Cependant, les propriétés de l'unité 30 diffèrent de celles de l'unité 10 en ce que la courbe M₃₀(D) associée (cf. courbe C₃₀ de la figure 10) présente un « plateau » (force de rappel sensiblement constante) pour une valeur de force de rappel élastique en valeur absolue inférieure à celle de l'unité 10 (environ 0,225N pour l'unité 30 contre 0,343N pour l'unité 10).

Dans ce dispositif 2, l'unité 10 est légèrement armée de Δ₁₀ₐᵣₘ = Δ₁₀ₘᵢₙ = 0.01mm, par translation de sa partie de liaison 11 le long de la droite (d) vers son support 13, pour que son comportement soit à la limite inférieure de la zone constante (au début du « plateau ») ; l'unité 30 est, quant à elle, fortement armée de Δ₃₀ₐᵣₘ = Δ₃₀ₘₐₓ = 1,4mm par translation de sa partie de liaison 31 le long de la droite (d) vers son support 33, pour que son comportement soit à la limite supérieure de la zone constante (à la fin du « plateau »). La figure 8c illustre schématiquement l'état d'armage des unités 10 et 30 du dispositif 2 représenté à la figure 10b.

Les sens des forces de rappel F₁₀, F₃₀ exercées respectivement par les unités 10, 30 suite à leur armage sont représentés respectivement par les flèches F₁₀ et F₃₀ sur la figure 10b.

Des butées 6 coopèrent avec une de chacune des paires de lames élastiques 12c de l'unité 10 et évitent que cette unité 10 dont la force de rappel élastique F₁₀ associée est, en valeur absolue, la plus importante, n'entraîne la partie de liaison 31 de l'unité 30 (dont la force de rappel F₃₀ associée est moins importante) vers son support 30 (vers le bas sur la figure 10b), ce qui reviendrait à l'armer au-delà de sa valeur Δ₃₀ₘₐₓ.

Le dispositif 2 est asymétrique et se comporte comme un ressort à force constante lors de la translation de l'élément à guider 100 en direction du support 13 de l'unité 10. Les figures 10a et 10b illustrent ce dispositif avant et après armage.

Dans le dispositif 2 tel que décrit ci-dessus, il n'existe pas de position d'équilibre d'armage à proprement parler. A l'état de repos du dispositif 2, l'unité 10 est armée de 0,01mm, l'unité 30 est armée de 1,4mm et la translation de l'élément à guider 100 le long de la droite (d) n'est possible que dans la direction de l'unité 10. Le dispositif 2 est en appui contre la butée 6 qui empêche la translation de l'élément à guider 100 vers l'unité 30. Cette position, représentée à la figure 10b, sera considérée dans la suite comme la position d'équilibre d'armage du dispositif 2.

Soit D la position de l'élément à guider 100 par rapport au bâti 3, D étant égal à zéro dans la position d'équilibre d'armage et augmentant lors de la translation de l'élément à guider 100 le long de la droite (d) en direction de l'unité 10.

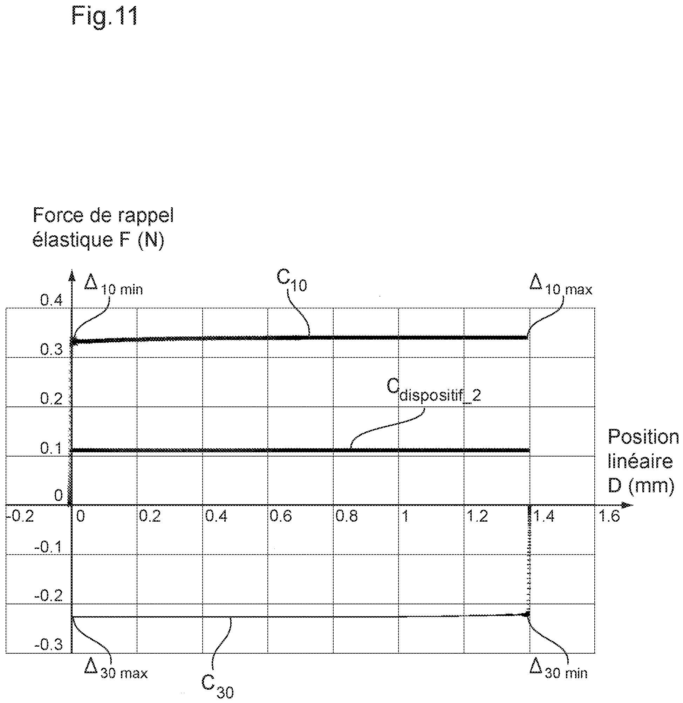

La courbe C₁₀ de la figure 11 correspond à la courbe F₁₀(D) de l'unité 10 et la courbe C₃₀ de la figure 11 correspond à la courbe F₃₀(D) de l'unité 30. Une force de rappel positive correspond à une force tendant à faire avancer l'élément à guider 100 le long de la droite (d), dans la direction de l'unité 30, c'est-à-dire vers le bas sur la figure 10b.

La courbe C₁₀ correspond à la courbe F₁₀(Δ₁₀) que l'on aurait pour l'unité 10 isolée et qui aurait subi, du fait de la phase d'armage, une translation de Δ₁₀ₐᵣₘ = 0,01mm vers la gauche. La force F₁₀ exercée par l'unité 10 tend à pousser l'élément à guider 100 vers l'unité 30 et est donc positive.

La courbe C₃₀ correspond à la symétrique de la courbe F₃₀(Δ₃₀) que l'on aurait pour l'unité 30 isolée par rapport au centre du repère et qui aurait subi une translation de Δ₃₀ₐᵣₘ = 1,4mm vers la droite. La force F₃₀ exercée par l'unité 30 tend à pousser l'élément à guider 100 vers l'unité 10 et est donc comptée négativement.

La courbe C_{dispositif_2} de la figure 11 illustre la force de rappel F(D) s'exerçant sur l'élément à guider 100 en fonction de sa position D, le long de la droite (d). Cette courbe correspond à la somme des courbes C₁₀ et C₃₀.

Comme cela est visible sur la figure 11, tant que la position D est telle que l'armage de chacune des deux unités 10, 30 reste dans la plage de valeurs [Δₘᵢₙ, Δₘₐₓ] = [0,01mm ; 1,4mm] qui lui est associée, les forces de rappels élastiques exercées par les deux unités 10, 30 sur l'élément à guider 100 sont sensiblement constantes et se compensent partiellement de sorte que la force de rappel résultante sur l'élément à guider 100 est sensiblement constante est abaissée par rapport à la force de rappel élastique de l'unité 10 considérée seule. Cela correspond à une plage de positions prédéterminées D de l'élément à guider 100 allant de D = 0mm à D=1,39mm, soit une plage prédéterminée de 1,39mm. Ainsi, la plage de positions prédéterminée du dispositif 2 selon le second mode de réalisation de l'invention correspond à la plage de chevauchement des plages [Δ₁₀,ₘᵢₙ Δ₁₀ₘₐₓ] et [Δ₃₀ₘᵢₙ, Δ₃₀ₘₐₓ] au sein du dispositif 2.

Les autres considérations se rapportant au premier mode de réalisation de l'invention restent valables pour ce second mode de réalisation. Par exemple, les supports 13, 33 des unités 10, 30 sont fixés sur un bâti 3, par exemple au moyen de vis 16, 36 insérées dans des trous 15, 35 des supports 13, 33.

Le dispositif 2 de l'ensemble horloger selon le second mode de réalisation de l'invention présente l'avantage de guider en translation sans frottement tout en permettant d'ajuster la valeur de la force de rappel s'exerçant sur l'élément à guider 100. En effet, cette force de rappel élastique s'obtient en faisant la différence entre les forces de rappel élastique exercées par chacune des unités 10, 30 du dispositif 2. Il est ainsi possible d'obtenir un guidage avec une force de rappel très faible tout en ayant des unités qui exercent chacune des forces de rappel pouvant être importantes.

Quel que soit le mode de réalisation de l'invention, le dispositif de guidage de l'ensemble horloger selon l'invention permet un guidage précis, sans frottements, d'un élément mobile en translation, ce guidage se faisant avec une force de rappel sensiblement constante dont la valeur peut être ajustée typiquement à une valeur faible voire sensiblement nulle bien que ce dispositif comprenne des organes élastiques de raideur pouvant être importante. L'agencement des organes élastiques du dispositif de guidage permet de diminuer la raideur ressentie au niveau de l'élément à guider dans le plan qu'il définit en se déplaçant en translation tout en conservant une raideur importante lors de déplacements de cet élément en dehors de ce plan.

Quel que soit le mode de réalisation de l'invention, le procédé de réalisation d'un ensemble horloger selon l'invention comprend les étapes successives suivantes :
a. Réaliser un dispositif comprenant les deux unités monolithiques 10, 20 ; 10, 30 jointes à l'élément mobile 100 ;
b. Armer chacune desdites deux unités 10, 20 ; 10, 30 ; et
c. Fixer l'élément fixe 13, 23 ; 13, 33 à un bâti 3,
ledit procédé comprenant également, lorsque l'élément mobile ne comprend pas le composant horloger, une étape consistant à assembler le composant horloger à l'élément mobile dudit dispositif. Cette dernière étape pouvant, lorsqu'elle est nécessaire, être réalisée à n'importe quel moment du procédé, c'est-à-dire par exemple avant l'étape a, entre les étapes a et b, entre les étapes b et c ou après l'étape c.

Il apparaitra clairement à l'homme du métier que la présente invention n'est en aucun cas limitée aux modes de réalisation présentés dans les figures.

Quel que soit le mode de réalisation considéré de l'invention, le dispositif 1, 2 a été décrit une fois armé et une fois les supports 13, 23 ou 13, 33 de ses unités 10, 20 ou 10, 30 fixés sur le bâti 3.

Les dispositifs 1 et 2 tels que décrits précédemment comportent chacun, préalablement à leur fixation sur le bâti 3, des supports respectivement 13 et 23 et 13 et 33, mobiles l'un par rapport à l'autre. L'armage de ces dispositifs peut typiquement s'effectuer par rapprochement desdits supports l'un de l'autre. Le fait que les supports soient mobiles l'un par rapport à l'autre avant leur fixation sur le bâti présente l'avantage de permettre d'ajuster au besoin les valeurs d'armage des unités en désolidarisant un des supports du bâti et en le rapprochant ou en l'éloignant de l'autre avant de le refixer sur le bâti.

Quel que soit le mode de réalisation de l'invention, il est envisageable de réaliser un ensemble dans lequel le dispositif 1, 2 est entièrement monolithique, c'est-à-dire pour lequel les deux unités 10, 20 ou 10, 30 et l'élément à guider 100 du dispositif forment un ensemble monolithique. Dans ce cas, les supports 13, 23 ou 13, 33 doivent être mobiles l'un par rapport à l'autre jusqu'à leur fixation pour permettre l'armage des unités. Pour obtenir un tel dispositif monolithique, un procédé tel que décrit dans le cadre du premier mode de réalisation de l'invention convient. Le dispositif intermédiaire dont il est question à l'étape a de ce procédé correspond alors à un dispositif monolithique comprenant les deux unités et l'élément à guider, l'étape a comprenant typiquement la gravure ou le moulage de ce dispositif intermédiaire monolithique qui peut par exemple être gravé dans une galette de silicium (communément désignée sous le nom de « wafer ») ou moulé en verre métallique. Il est également envisageable de réaliser un ensemble horloger selon l'invention entièrement monolithique, l'élément mobile comprenant typiquement ledit composant horloger.

Un des avantages d'un tel dispositif monolithique selon l'invention est qu'il est fabricable en une seule étape. Il est en outre facile à placer dans un mécanisme horloger et également très aisément réglable sur le bâti, ceci avec une grande précision.

Dans des variantes de l'invention, il est envisageable de réaliser un ensemble selon l'invention dans lequel le dispositif 1 ; 2 comprend des unités avec des lames élastiques de formes différentes de celles représentées dans les figures et/ou dont le nombre de lames élastiques est différent de celui représenté dans les figures, les lames pouvant avoir une section constante ou une section variable.

Il est également envisageable de positionner les unités du dispositif de l'ensemble selon l'invention dans des plans différents, par exemple l'une au-dessus de l'autre dans des plans parallèles, ou bien dans des plans différents non parallèles, typiquement en faisant pivoter une des unités de x° autour de la droite (d). Cette dernière configuration présente l'avantage de diminuer le risque de déformation des lames élastiques de chacune des unités en dehors du plan qu'elles définissent lorsqu'elles sont au repos, cela est par exemple particulièrement avantageux dans le cas du guidage d'un élément 100 massif, type masse de remontoir. Il est possible de compenser ledit risque de déformation des lames élastiques en adaptant le matériau utilisé pour les réaliser.

## Revendications

1. Ensemble horloger comprenant un composant horloger et un dispositif (1 ; 2) comprenant un élément fixe (13, 23, 33), un élément mobile (100) et des premier (12) et deuxième (22 ; 32) organes élastiques reliant l'élément fixe (13, 23, 33) et l'élément mobile (100) et étant agencés pour guider l'élément mobile (100) en translation par rapport audit élément fixe (13, 23, 33), **caractérisé en ce que**
chacun des premier (12) et deuxième (22 ; 32) organes élastiques est agencé pour exercer sur l'élément mobile (100) une force de rappel élastique sensiblement constante sur une plage prédéterminée de positions de l'élément mobile (100) par rapport à l'élément fixe (13, 23, 33), les forces de rappel élastique exercées par les premier (12) et deuxième (22 ; 32) organes élastiques se compensant au moins partiellement dans toute ladite plage prédéterminée.

2. Ensemble horloger selon la revendication 1, **caractérisé en ce que** le composant horloger est solidaire en translation de l'élément mobile.

3. Ensemble horloger selon la revendication 1 ou 2, **caractérisé en ce que** l'élément mobile comprend le composant horloger.

4. Ensemble horloger selon la revendication 1, **caractérisé en ce que** le composant horloger est agencé pour coopérer avec l'élément mobile lorsque celui-ci est mobile en translation.

5. Ensemble horloger selon l'une quelconque des revendications 1 à 4, **caractérisé en ce que** le dispositif (1 ; 2) comprend une première unité monolithique (10) comprenant une première partie de liaison (11) jointe à l'élément mobile (100), ledit premier organe élastique (12) et une première partie (13) de l'élément fixe, ledit premier organe élastique (12) reliant lesdites premières parties (11, 13), et une deuxième unité monolithique (20 ; 30) comprenant une seconde partie de liaison (21 ; 31) jointe à l'élément mobile (100), ledit deuxième organe élastique (22 ; 32) et une seconde partie (23 ; 33) de l'élément fixe, ledit deuxième organe élastique (22 ; 32) reliant lesdites secondes parties (21, 23 ; 31, 33).

6. Ensemble horloger selon la revendication 5, **caractérisé en ce que** les deux unités monolithiques (10, 20, 30) et l'élément mobile (100) du dispositif forment un ensemble monolithique.

7. Ensemble horloger selon l'une des revendications précédentes, **caractérisé en ce que** chacun desdits premier (12) et deuxième (22 ; 32) organes élastiques du dispositif comprend plusieurs lames élastiques (12a, 12b, 12c, 22a, 22b, 22c, 32a, 32b, 32c).

8. Ensemble horloger selon la revendication 7, **caractérisé en ce que** les premier (12) et deuxième (22 ; 32) organes élastiques du dispositif comprennent chacun au moins une lame élastique (12a, 22a, 32a) travaillant en flambage et au moins une lame élastique (12b, 12c, 22b, 22c, 32b, 32c) travaillant en flexion.

9. Ensemble horloger selon la revendication 8, **caractérisé en ce que** chacune des unités (10, 20, 30) du dispositif est apte à exercer une force de rappel élastique sensiblement constante sur une plage de positions [Δₘᵢₙ, Δₘₐₓ] de sa partie de liaison (11, 21, 31) par rapport à la partie (13, 23, 33) de l'élément fixe à laquelle elle est associée,
Δ étant croissant dans le sens du déplacement de la partie de liaison (11, 21, 31) de l'unité (10, 20, 30) considérée entraînant un effort de compression sur ladite au moins une lame élastique (12a, 22a, 32a) travaillant en flambage,
**en ce que** les sens des forces de rappel élastique exercées par chacune des unités (10, 20, 30) sont opposés,
et **en ce que**, à l'état de repos du dispositif (1 ; 2), chacune desdites unités (10, 20, 30) est armée d'une valeur Δarm, cette valeur Δarm étant, pour chaque unité (10, 20, 30) comprise entre les valeurs Δmin et Δmax associées à cette unité (10, 20, 30), les valeurs Δmin, Δmax et/ou Δarm pouvant être identiques ou différentes d'une unité à l'autre.

10. Ensemble horloger selon la revendication 9, **caractérisé en ce que**, pour chacune desdites unités (10, 20, 30), Δarm = Δmin + ((Δmax - Δmin)/2).

11. Ensemble horloger selon l'une des revendications précédentes, **caractérisé en ce que** les forces de rappel élastique exercées par les premier (12) et deuxième (22 ; 32) organes élastiques du dispositif se compensent presque totalement dans toute ladite plage prédéterminée.

12. Ensemble horloger selon l'une des revendications précédentes, **caractérisé en ce que** les premier (12) et deuxième (22) organes élastiques du dispositif sont identiques.

13. Ensemble horloger selon l'une quelconque des revendications 5 à 12, **caractérisé en ce que** la première unité monolithique et la deuxième unité monolithique sont différentes l'une de l'autre, les premier (12) et deuxième (22) organes élastiques du dispositif étant différents l'un de l'autre.

14. Ensemble horloger selon l'une des revendications précédentes, **caractérisé en ce que** ladite plage prédéterminée de positions de l'élément mobile (100) par rapport à l'élément fixe du dispositif, inclut l'ensemble des positions que peut prendre l'élément mobile (100).

15. Ensemble horloger selon l'une des revendications précédentes, **caractérisé en ce que** le dispositif comprend des butées (14, 24, 34) limitant les positions que peut prendre ledit élément mobile (100) à ladite plage prédéterminée de positions.

16. Ensemble horloger selon l'une des revendications 1 à 15, **caractérisé en ce que** le composant horloger est une ancre d'échappement, une crémaillère, une masse de remontage, une roue ou une partie d'une bielle d'un système conjuguant came et bielle.

17. Procédé de réalisation d'un ensemble horloger selon l'une des revendications 6 à 16, **caractérisé en ce qu'**il comprend les étapes successives suivantes :
a. Réaliser un dispositif comprenant les deux unités monolithiques (10, 20, 30) jointes à l'élément mobile ;
b. Armer chacune desdites deux unités (10, 20, 30) ;
c. Fixer l'élément fixe (13 ; 23 ; 33) à un bâti (3) ;
ledit procédé étant également **caractérisé en ce que**, lorsque l'élément mobile ne comprend pas le composant horloger, il comprend en outre une étape consistant à assembler le composant horloger à l'élément mobile dudit dispositif.

18. Procédé selon la revendication 17, **caractérisé en ce que** l'étape a comprend la gravure ou le moulage d'un dispositif monolithique comprenant lesdites deux unités (10, 20, 30) et l'élément mobile.

19. Procédé selon la revendication 17 ou 18 **caractérisé en ce que** l'étape (d) est réalisée par introduction de moyens d'attache (16, 26) dans des trous (15, 25) de chacune des parties (13, 23, 33) de l'élément fixe.

20. Pièce d'horlogerie, telle qu'une montre bracelet, une montre de poche, une pendule ou une pendulette, comprenant un ensemble horloger selon l'une quelconque des revendications 1 à 16.

## Patentansprüche

1. Uhrenanordnung mit einer Uhrenkomponente und mit einer Vorrichtung (1; 2), die ein festes Element (13, 23, 33), ein bewegliches Element (100) und ein erstes (12) und ein zweites (22; 32) elastisches Organ umfasst, die das feste Element (13, 23, 33) und das bewegliche Element (100) verbinden und dazu gestaltet sind, das bewegliche Element (100) translatorisch in Bezug auf das feste Element (13, 23, 33) zu führen,
**dadurch gekennzeichnet, dass** jedes von dem ersten (12) und dem zweiten (22; 32) elastischen Organ dazu gestaltet ist, auf das bewegliche Element (100) eine elastische Rückstellkraft auszuüben, die über einen vorbestimmten Bereich von Positionen des beweglichen Elements (100) in Bezug auf das feste Element (13, 23, 33) konstant ist, wobei die elastischen Rückstellkräfte, die von dem ersten (12) und dem zweiten (22; 32) elastischen Organ ausgeübt werden, sich im gesamten vorbestimmten Bereich zumindest teilweise ausgleichen.

2. Uhrenanordnung nach Anspruch 1, **dadurch gekennzeichnet, dass** die Uhrenkomponente translatorisch fest mit dem beweglichen Element verbunden ist.

3. Uhrenanordnung nach Anspruch 1 oder 2, **dadurch gekennzeichnet, dass** das bewegliche Element die Uhrenkomponente umfasst.

4. Uhrenanordnung nach Anspruch 1, **dadurch gekennzeichnet, dass** die Uhrenkomponente dazu gestaltet ist, mit dem beweglichen Element zusammenzuwirken, wenn dieses translatorisch beweglich ist.

5. Uhrenanordnung nach einem der Ansprüche 1 bis 4, **dadurch gekennzeichnet, dass** die Vorrichtung (1; 2) eine erste monolithische Einheit (10) umfasst, die einen ersten Verbindungsteil (11), der mit dem beweglichen Element (100) verbunden ist, das erste elastische Organ (12) und einen ersten Teil (13) des festen Elements umfasst, wobei das erste elastische Organ (12) die ersten Teile (11, 13) verbindet, und eine zweite monolithische Einheit (20; 30) umfasst, die einen zweiten Verbindungsteil (21; 31), der mit dem beweglichen Element (100) verbunden ist, das zweite elastische Organ (22; 32) und einen zweiten Teil (23; 33) des festen Elements umfasst, wobei das zweite elastische Organ (22; 32) die zweiten Teile (21, 23; 31, 33) verbindet.

6. Uhrenanordnung nach Anspruch 5, **dadurch gekennzeichnet, dass** die zwei monolithischen Einheiten (10, 20, 30) und das bewegliche Element (100) der Vorrichtung eine monolithische Anordnung bilden.

7. Uhrenanordnung nach einem der vorhergehenden Ansprüche, **dadurch gekennzeichnet, dass** jedes von dem ersten (12) und dem zweiten (22; 32) elastischen Organ der Vorrichtung mehrere elastische Klingen (12a, 12b, 12c, 22a, 22b, 22c, 32a, 32b, 32c) umfasst.

8. Uhrenanordnung nach Anspruch 7, **dadurch gekennzeichnet, dass** das erste (12) und das zweite elastische Organ (22; 32) der Vorrichtung jeweils mindestens eine elastische Klinge (12a, 22a, 32a), die in Knickung wirkt, und mindestens eine elastische Klinge (12b, 12c, 22b, 22c, 32b, 32c) umfassen, die in Biegung wirkt.

9. Uhrenanordnung nach Anspruch 8, **dadurch gekennzeichnet, dass** jede der Einheiten (10, 20, 30) der Vorrichtung geeignet ist, eine elastische Rückstellkraft auszuüben, die über einen Bereich von Positionen [Δmin, Δmax] ihres Verbindungsteils (11, 21, 31) in Bezug auf den Teil (13, 23, 33) des festen Elements, dem sie zugehörig ist, im Wesentlichen konstant ist,
wobei Δ in der Richtung der Verlagerung des Verbindungsteils (11, 21, 31) der betrachteten Einheit (10, 20, 30) zunimmt, wodurch eine Zusammendrückkraft auf die mindestens eine elastische Klinge (12a, 22a, 32a) bewirkt wird, die in Knickung wirkt,
und dadurch, dass die elastischen Rückstellkräfte, die von jeder der Einheiten (10, 20, 30) ausgeübt werden, entgegengesetzt sind,
und dadurch, dass im Ruhezustand der Vorrichtung (1; 2) jede der Einheiten (10, 20, 30) mit einem Wert Δarm gespannt ist, wobei dieser Wert Δarm für jede Einheit (10, 20, 30) zwischen den Werten Δmin und Δmax, die dieser Einheit (10, 20, 30) zugehörig sind, enthalten ist, wobei die Werte Δmin, Δmax und/oder Δarm miteinander identisch oder voneinander verschieden sein können.

10. Uhrenanordnung nach Anspruch 9, **dadurch gekennzeichnet, dass** für jede der Einheiten (10, 20, 30) Δarm = Δmin + ((Δmax - Δmin)/2).

11. Uhrenanordnung nach einem der vorhergehenden Ansprüche, **dadurch gekennzeichnet, dass** die elastischen Rückstellkräfte, die von dem ersten (12) und dem zweiten (22; 32) elastischen Organ der Vorrichtung ausgeübt werden, sich im gesamten vorbestimmten Bereich fast vollständig ausgleichen.

12. Uhrenanordnung nach einem der vorhergehenden Ansprüche, **dadurch gekennzeichnet, dass** das erste (12) und das zweite (22) elastische Organ der Vorrichtung identisch sind.

13. Uhrenanordnung nach einem der Ansprüche 5 bis 12, **dadurch gekennzeichnet, dass** die erste monolithische Einheit und die zweite monolithische Einheit sich voneinander unterscheiden, wobei das erste (12) und das zweite elastische Organ (22) der Vorrichtung sich voneinander unterscheiden.

14. Uhrenanordnung nach einem der vorhergehenden Ansprüche, **dadurch gekennzeichnet, dass** der vorbestimmte Bereich von Positionen des beweglichen Elements (100) in Bezug auf das feste Element der Vorrichtung sämtliche Positionen umfasst, die das bewegliche Element (100) einnehmen kann.

15. Uhrenanordnung nach einem der vorhergehenden Ansprüche, **dadurch gekennzeichnet, dass** die Vorrichtung Anschläge (14, 24, 34) umfasst, welche die Positionen, die das bewegliche Element (100) einnehmen kann, auf den vorbestimmten Bereich von Positionen begrenzen.

16. Uhrenanordnung nach einem der Ansprüche 1 bis 15, **dadurch gekennzeichnet, dass** die Uhrenkomponente ein Hemmungsanker, eine Zahnstange, eine Aufzugsmasse, ein Rad oder ein Teil einer Kurbelstange eines Systems ist, das Kurvenscheibe und Kurbelstange vereint.

17. Verfahren zur Herstellung einer Uhrenanordnung nach einem der Ansprüche 6 bis 16, **dadurch gekennzeichnet, dass** es die folgenden aufeinanderfolgenden Schritte umfasst:
a. Herstellen einer Vorrichtung, welche die zwei monolithischen Einheiten (10, 20, 30) umfasst, die mit dem beweglichen Element verbunden sind;
b. Spannen jeder der zwei Einheiten (10, 20, 30);
c. Befestigen des festen Elements (13; 23; 33) an einem Gestell (3);
wobei das Verfahren ferner **dadurch gekennzeichnet ist, dass**, wenn das bewegliche Element die Uhrenkomponente nicht umfasst, es ferner einen Schritt umfasst, der im Zusammenbauen der Uhrenkomponente mit dem beweglichen Element der Vorrichtung besteht.

18. Verfahren nach Anspruch 17, **dadurch gekennzeichnet, dass** der Schritt a das Ätzen oder das Formen einer monolithischen Vorrichtung umfasst, welche die zwei Einheiten (10, 20, 30) des beweglichen Elements umfasst.

19. Verfahren nach Anspruch 17 oder 18, **dadurch gekennzeichnet, dass** der Schritt (d) durch Einführen von Anbringungsmitteln (16, 26) in Löcher (15, 25) von jedem der Teile (13, 23, 33) des festen Elements ausgeführt wird.

20. Uhrenteil, wie beispielsweise einer Armbanduhr, einer Taschenuhr, einer Pendeluhr oder einer Pendulette, das eine Uhrenanordnung nach einem der Ansprüche 1 bis 16 umfasst.

## Claims

1. Timepiece assembly comprising a timepiece component and a device (1; 2) comprising a fixed element (13, 23, 33), a movable element (100) and first (12) and second (22; 32) elastic members connecting the fixed element (13, 23, 33) and the movable element (100) and being arranged to guide the movable element (100) in translation with respect to said fixed element (13, 23, 33), **characterised in that** each of the first (12) and second (22; 32) elastic members is arranged to exert on the movable element (100) a substantially constant elastic return force over a predetermined range of positions of the movable element (100) with respect to the fixed element (13, 23, 33), the elastic return forces exerted by the first (12) and second (22; 32) elastic members compensating for each other at least partially throughout said predetermined range.

2. Timepiece assembly as claimed in claim 1, **characterised in that** the timepiece component moves in conjoint translation with the movable element.

3. Timepiece assembly as claimed in claim 1 or 2, **characterised in that** the movable element comprises the timepiece component.

4. Timepiece assembly as claimed in claim 1, **characterised in that** the timepiece component is arranged to cooperate with the movable element when this movable element is moving in translation.

5. Timepiece assembly as claimed in any one of claims 1 to 4, **characterised in that** the device (1; 2) comprises a first single-piece unit (10) comprising a first connecting part (11) joined to the movable element (100), said first elastic member (12) and a first part (13) of the fixed element, said first elastic member (12) connecting said first parts (11, 13), and a second single-piece unit (20; 30) comprising a second connecting part (21; 31) joined to the movable element (100), said second elastic member (22; 32) and a second part (23; 33) of the fixed element, said second elastic member (22; 32) connecting said second parts (21, 23; 31, 33).

6. Timepiece assembly as claimed in claim 5, **characterised in that** the two single-piece units (10, 20, 30) and the movable element (100) of the device form a single-piece assembly.

7. Timepiece assembly as claimed in any one of the preceding claims, **characterised in that** each of said first (12) and second (22; 32) elastic members of the device comprises a plurality of elastic strips (12a, 12b, 12c, 22a, 22b, 22c, 32a, 32b, 32c).

8. Timepiece assembly as claimed in claim 7, **characterised in that** the first (12) and second (22; 32) elastic members of the device each comprise at least one elastic strip (12a, 22a, 32a) working in a buckling manner and at least one elastic strip (12b, 12c, 22b, 22c, 32b, 32c) working in a flexing manner.

9. Timepiece assembly as claimed in claim 8, **characterised in that** each of the units (10, 20, 30) of the device is able to exert a substantially constant elastic return force over a range of positions [Δₘᵢₙ, Δₘₐₓ] of its connecting part (11, 21, 31) with respect to the part (13, 23, 33) of the fixed element with which it is associated,
Δ increasing in the direction of the displacement of the connecting part (11, 21, 31) of the unit (10, 20, 30) in question leading to a compression force on said at least one elastic strip (12a, 22a, 32a) working in a buckling manner,
**in that** the directions of the elastic return forces exerted by each of the units (10, 20, 30) are opposing,
and **in that**, when the device (1; 2) is in the inoperative state, each of said units (10, 20, 30) is charged by a value Δarm, this value Δarm being, for each unit (10, 20, 30), between the values Δmin and Δmax associated with this unit (10, 20, 30), the values Δmin, Δmax and/or Δarm being able to be identical or different from one unit to another.

10. Timepiece assembly as claimed in claim 9, **characterised in that**, for each of said units (10, 20, 30), Δarm = Δmin + ((Δmax - Δmin)/2).

11. Timepiece assembly as claimed in any one of the preceding claims, **characterised in that** the elastic return forces exerted by the first (12) and second (22; 32) elastic members of the device compensate for each other almost entirely throughout said predetermined range.

12. Timepiece assembly as claimed in any one of the preceding claims, **characterised in that** the first (12) and second (22) elastic members of the device are identical.

13. Timepiece assembly as claimed in any one of claims 5 to 12, **characterised in that** the first single-piece unit and the second single-piece unit are different from each other, the first (12) and second (22) elastic members of the device being different from each other.

14. Timepiece assembly as claimed in any one of the preceding claims, **characterised in that** said predetermined range of positions of the movable element (100) with respect to the fixed element of the device includes all of the positions which the movable element (100) can adopt.

15. Timepiece assembly as claimed in any one of the preceding claims, **characterised in that** the device comprises stops (14, 24, 34) limiting the positions which said movable element (100) can adopt to said predetermined range of positions.

16. Timepiece assembly as claimed in any one of claims 1 to 15, **characterised in that** the timepiece component is an escapement anchor, a rack, a winding mass, a wheel or a part of a rod of a system combining a cam and rod.

17. Method for producing a timepiece assembly as claimed in any one of claims 6 to 16, **characterised in that** it comprises the following successive steps:
a. producing a device comprising the two single-piece units (10, 20, 30) joined to the movable element;
b. charging each of said two units (10, 20, 30);
c. fixing the fixed element (13; 23; 33) to a frame (3);
said method also being **characterised in that**, when the movable element does not comprise the timepiece component, it also comprises a step consisting of mounting the timepiece component on the movable element of said device.

18. Method as claimed in claim 17, **characterised in that** step a comprises the etching or the moulding of a single-piece device comprising said two units (10, 20, 30) and the movable element.

19. Method as claimed in claim 17 or 18 **characterised in that** step (d) is carried out by introduction of attachment means (16, 26) into holes (15, 25) of each of the parts (13, 23, 33) of the fixed element.

20. Timepiece such as a wristwatch, a pocket watch, a clock or a miniature clock, comprising a timepiece assembly as claimed in any one of claims 1 to 16.
